# EUROPÄISCHE PATENTSCHRIFT

(11) **EP 3 465 814 B1**
(45) Veröffentlichungstag und Bekanntmachung des Hinweises auf die Patenterteilung: **17.04.2024**
(21) Anmeldenummer: 16729829.8
(22) Anmeldetag: 06.06.2016
(51) Int. Cl.: H01M 10/42, H01M 6/50, G01R 31/36, G01R 31/385, H01M 10/48, H01M 10/615, H01M 10/613

(54) **TESTZELLENSTATION FÜR MINDESTENS EINE ELEKTROCHEMISCHE TESTZELLE**
TEST CELL STATION FOR AT LEAST ONE ELECTROCHEMICAL TEST CELL
STATION DE CELLULES DE TEST POUR AU MOINS UNE CELLULE DE TEST ÉLECTROCHIMIQUE

(43) Veröffentlichungstag der Anmeldung: 10.04.2019
(73) Patentinhaber: El-Cell GmbH, 21079 Hamburg (DE)
(72) Erfinder: HAHN, Michael, 22589 Hamburg (DE); HAHN, Matthias, 30890 Barsinghausen/Kirchdorf (DE)
(74) Vertreter: Müller Verweyen
(86) Internationale Anmeldenummer: PCT/EP2016/062782
(87) Internationale Veröffentlichungsnummer: WO 2017/211379

(56) Entgegenhaltungen:
- CN-U- 202 975 311
- CN-Y- 201 319 060
- DE-A1-102012 206 917
- DE-A1-102015 118 454
- US-A- 3 876 931

## Beschreibung

Die Erfindung betrifft eine Testzellenstation für mindestens eine elektrochemische Testzelle, umfassend ein Gehäuse, mindestens eine Aufnahme zum kontaktierenden Einsetzen mindestens einer elektrochemischen Testzelle und elektrische Verbindungsmittel zur elektrischen Verbindung einer in die Aufnahme eingesetzten Testzelle.

In der Forschung und Entwicklung von elektrochemischen Speicherzellen, beispielsweise Lithium-Ionen-Akkus, werden elektrochemische Testzellen zur Charakterisierung der Batteriematerialien verwendet. Die Testzellen weisen externe elektrische Anschlüsse auf, die mit in wechselseitigem Elektrolytkontakt stehenden internen Elektroden verbunden sind. Zur Messung werden die Testzellen in entsprechende Aufnahmen einer Testzellenstation eingesetzt und darin arretiert, wodurch ein elektrischer Kontakt der externen Anschlüsse mit elektrischen Verbindungsmitteln hergestellt wird, über die die Testzellen mit einer Batterietestvorrichtung verbindbar sind. Über die externen Anschlüsse werden mittels der Batterietestvorrichtung elektrische Kennlinien zur Charakterisierung der verwendeten Batteriematerialien aufgenommen, beispielsweise Strom-/Spannungskennlinien, Konstantstrom-Zyklen, Impedanzspektren.

Eine Testzellenstation der Anmelderin zur Aufnahme von bis zu 16 Testzellen ist unter dem Namen PAT-Tray bekannt. Da die Messung unter definierten Temperaturbedingungen durchzuführen ist, ist es bekannt, die Testzellenstation während der Messung in eine separate, verschließbare Temperaturkammer in der Art eines Kühlschranks einzustellen. Mit einer aufwändigen Kabeldurchführung durch die Temperaturkammer nach außen wird die Testzellenstation über eine der Anzahl der Testzellenaufnahmen entsprechende Anzahl von Kabeln mit einem externen Batterietester verbunden, der außerhalb der Temperaturkammer steht. Beim elektrischen Test der Zellen kann es erforderlich sein, die individuelle Verbindung zwischen den Anschlüssen der Testzelle und den entsprechenden Anschlüssen des zugeordneten Batterietesterkanals zu ändern. Solche Änderungen der Testzellenbeschaltung erfolgen manuell und werden manuell dokumentiert, was aufwändig und fehleranfällig ist.

Die DE 10 2015 118454 A1 offenbart ein Batterietestsystem mit den Merkmalen des Oberbegriffs von Anspruch 1.

Die CN 202 975 311 U offenbart eine Testplattform für ein Batteriemanagementsystem.

US 3 876 931 A offenbart eine Vorrichtung zur Bestimmung eines Batterieverhaltens.

Die Aufgabe der Erfindung besteht darin, eine weiter verbesserte Testzellenstation zum Testen von elektrochemischen Zellen mit hohem Durchsatz bereitzustellen.

Die Erfindung löst die Aufgabe mit den Merkmalen des unabhängigen Anspruches.

Die Erfindung stellt eine Testzellenstation als integriertes Gerät mit der Funktion einer Dockingstation für die Testzellen und einer Temperaturkammer bereit. Aufgrund der Integration der Temperaturkammer in die Testzellenstation ist eine separate Temperaturkammer entbehrlich, was die Gesamtkosten signifikant reduziert.

Erfindungsgemäß ist für jede Testzelle eine Batterietestvorrichtung mit einem steuerbaren Potentiostat und/oder Galvanostat in die Testzellenstation integriert. In dieser Ausführungsform entfällt die aufwändige und fehleranfällige individuelle Verkabelung zwischen der Dockingstation und einer externen Batterietestvorrichtung durch den Bediener und damit auch die durch die Verkabelung entstehenden Messartefakte. Die Batterietestvorrichtung ist erfindungsgemäß in dem Gehäuse außerhalb der Temperaturkammer angeordnet.

Vorteilhaft weist jede Batterietestvorrichtung eine steuerbare elektronische Schaltmatrix auf, insbesondere in Form einer Mehrzahl von Schaltern, wie Halbleiterschaltern oder Relais, mit der die Anschlüsse des jeweiligen Potentio-/Galvanostaten (Arbeits-, Gegen-, Referenzelektrode) beliebig mit den Anschlüssen der entsprechenden Testzelle (Anode, Kathode, Referenzelektrode) verbunden werden können. Hierdurch können fehleranfällige und zeitaufwändige manuelle Änderungen der Testzellenbeschaltung durch Umstecken von elektrischen Kabeln entfallen.

Vorteilhaft umfasst jede Batterietestvorrichtung eine digitale Steuerungseinrichtung zum Steuern des entsprechenden Potentio-/Galvanostaten und/oder der entsprechenden Schaltmatrix. Auch eine automatische Dokumentation der Testzellenbeschaltung und/oder Datenaufzeichnung ist mittels der Steuerungseinrichtung einfach möglich.

In einer einfachen und daher vorteilhaften Ausführungsform ist die Kühl-/Heizeinrichtung ein Peltierelement bzw. ein elektrothermischer Wandler, wobei die eine thermische Seite (im Kühlbetrieb die Kühlseite) mit dem Innenraum und die andere thermische Seite (im Kühlbetrieb die Warmseite) mit dem Außenraum der Temperaturkammer in Verbindung steht. Es ist aber nicht ausgeschlossen, dass die Kühl-/Heizeinrichtung beispielsweise eine mit einem Kältemittel arbeitende Kältemaschine, insbesondere eine Kompressor- oder Absorper-Kältemaschine ist.

Vorteilhaft ist an dem Gehäuse eine thermisch isolierte, verstellbare Klappe zum Öffnen bzw. Verschließen einer GehäuseÖffnung in der Temperaturkammer verstellbar, d.h. verschwenkbar und/oder verschiebbar, angeordnet. Dies ermöglicht bei geöffneter Klappe ein einfaches und schnelles Einsetzen bzw. Herausnehmen von Testzellen in die bzw. aus der Temperaturkammer durch die Gehäuseöffnung und bei geschlossener Klappe eine verzögerungsfreie Durchführung der Messung. In einer anderen vorteilhaften Ausführungsform ist die Dockingstation mit den Testzellenaufnahmen in einem aus dem Gehäuse herausziehbaren und wieder einschiebbaren Schubelement angeordnet, das eine thermisch isolierte Frontwand aufweist. Dies ermöglicht bei herausgezogenem Schubelement ein einfaches und schnelles Einsetzen bzw. Herausnehmen von Testzellen in die bzw. aus der Temperaturkammer und bei eingeschobenem Schubelement eine verzögerungsfreie Durchführung der Messung.

Die elektrische Verbindung zwischen einer im Inneren des Gehäuses angeordneten Platine und der Testzelle kann vorteilhaft mittels doppelt wirkenden Federkontaktstiften erfolgen, die an ihrem einen Ende zur federnden Kontaktierung von Kontakten an der Testzelle und an dem anderen Ende zur direkten, federnden Kontaktierung von Kontakten auf der Platine eingerichtet sind. Damit werden herkömmliche Kabelverbindungen an dieser Stelle überflüssig.

Die erfindungsgemäße Testzelle ist vorteilhaft für die Forschung und Entwicklung von elektrochemischen Speicherzellen, insbesondere elektrochemischen Sekundärzellen bzw. Sekundärbatterien einschließlich sogenannter Coin cells, elektrochemischen Primärzellen und elektrochemischen Kondensatoren, beispielsweise Doppelschichtkondensatoren, vorgesehen.

Die Erfindung wird im Folgenden anhand bevorzugter Ausführungsformen unter Bezugnahme auf die beigefügten Figuren erläutert. Dabei zeigt:
- Fig. 1: eine perspektivische Ansicht einer Testzellenstation zur Aufnahme einer Mehrzahl von elektrochemischen Testzellen;
- Fig. 2: eine Querschnittsansicht der Testzellenstation aus Figur 1;

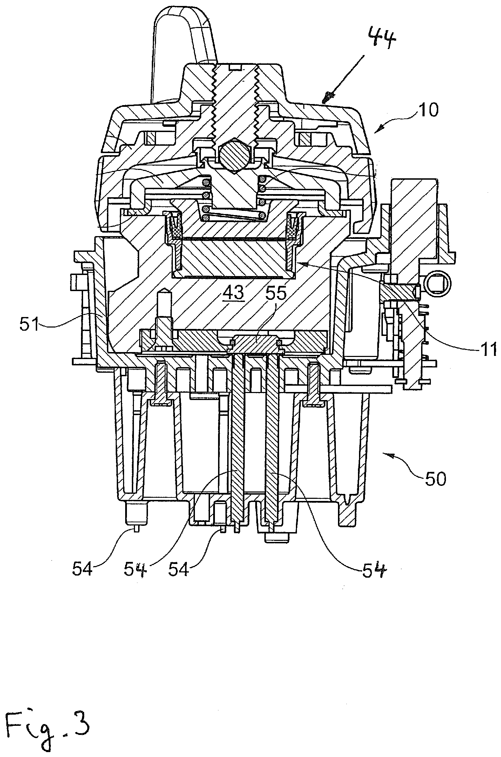

- Fig. 3: eine Querschnittsansicht einer Testzellenaufnahme mit einer eingesetzten elektrochemischen Testzelle;
- Fig. 4: eine perspektivische Ansicht einer weiteren erfindungsgemäßen Testzellenstation; und
- Fig. 5, 6: perspektivische Ansichten einer elektrochemischen Testzelle von schräg oben und schräg unten.

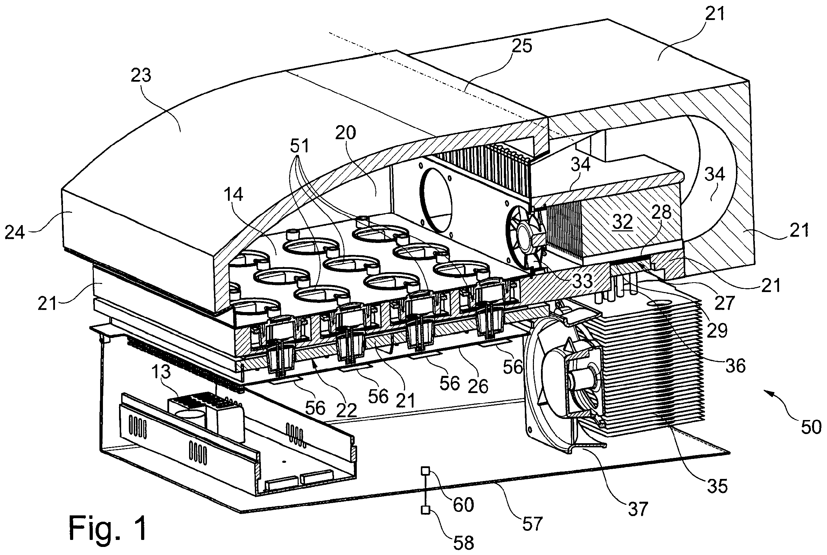

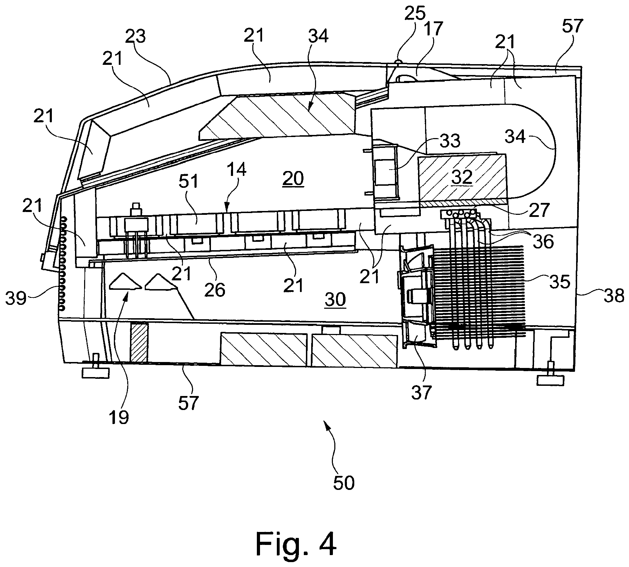

Die Testzellenstation 50 gemäß Figuren 1, 2 und 4 umfasst ein Gehäuse 57 und eine wärmeisolierte Temperaturkammer 20 mit einer Mehrzahl von hier sechzehn Aufnahmen 51 für jeweils eine elektrochemische Testzelle 10. Die Temperaturkammer 20 wird durch Isolierelemente oder -wände 21 aus einem wärmeisolierenden Material gebildet, siehe insbesondere Figur 4, die teilweise an der Innenseite des Gehäuses 57 angeordnet sein können. Eine Klappe 23 ist vorteilhaft unverlierbar an dem Gehäuse 57 angebracht und zwischen einer Offenstellung und einer Geschlossenstellung verstellbar. In den Figuren 1, 2 und 4 befindet sich die Klappe 23 in der Geschlossenstellung.

Die Klappe 23 weist vorteilhaft eine Handhabe 24 zur Bedienung auf und ist um eine vorzugsweise im hinteren Bereich der Klappe 23 angeordnete horizontale Schwenkachse 25 schwenkbar, wozu sie an dem Schwenklager 17 befestigt ist, siehe Figur 4. Bei vollständig nach oben geschwenkter, geöffneter Klappe 23 (Offenstellung) wird eine Bedienöffnung in dem Gehäuse 57 freigegeben, die ausreichend dimensioniert und angeordnet ist, um einem Bediener das Einsetzen und Herausnehmen von elektrochemischen Testzellen 10 in die bzw. aus der Temperaturkammer 20 zu ermöglichen.

Die Aufnahmen 51 sind vorteilhaft in einer horizontalen, hier thermisch isolierten Zwischenwand 22 in dem Gehäuse 57 angeordnet und können beispielsweise aus Kunststoff bestehen. Eine Testzellenaufnahme 51 mit eingesetzter Testzelle 10 ist im Querschnitt in Figur 4 gezeigt. Die Testzelle 10 ist mit definierter Orientierung in die Aufnahme 51 einsetzbar, was beispielsweise durch eine entsprechende Formung der Aufnahme 51 in Zusammenwirken mit einem entsprechend geformten Sockel 43 der Testzelle 10, hier einer planen seitlichen Oberfläche 52, oder mittels eines anderen Orientierungsmittels erreicht werden kann.

Im eingesetzten Zustand ist eine Zelle mittels einer nicht gezeigten Verriegelungsmechanik in der entsprechenden Aufnahme 51 fixierbar. Die Gesamtheit der Aufnahmen 51 bildet somit eine einheitliche Docking-Station 14 für elektrochemische Testzellen 10. In dem in der jeweiligen Aufnahme 51 fixierten Zustand sind die Testzellen 10 vollständig oder im Wesentlichen vollständig innerhalb der Temperaturkammer 20 angeordnet.

Unterhalb der Aufnahme 51 sind doppeltwirkende Federkontaktstifte 54 vorgesehen, die bei in die Aufnahme 51 eingesetzter Zelle 10 einerseits unter Federvorspannung an den externen Kontaktanschlüssen 40, 48, 49, 55 der Zelle 10 anliegen und andererseits unter Federvorspannung an Kontakten einer in der Testzellenstation 50 vorgesehenen Platine 26 anliegen. Mittels der doppeltwirkenden Federkontaktstifte 54 sind störende und anfällige Kabelverbindungen vermeidbar. Die Federkontaktstifte 54 sind durch die Temperaturkammerwand bzw. durch die Isolierelemente 21 geführt, um die elektrische Verbindung der in der Temperaturkammer 20 angeordneten Testzellen mit dem Außenraum 30 herzustellen. Die Testzellen 10 sind somit in dieser Ausführungsform gegenüber der Platine 26 thermisch isoliert.

In dem Gehäuse 57 der Testzellenstation 50 ist vorzugsweise ein Netzteil zur Spannungs-/Stromversorgung der elektrischen Einrichtungen vorgesehen. In der Testzellenstation 50 kann eine Zugentlastung 19 für elektrische Kabel vorgesehen sein, siehe Figur 4.

In der Testzellenstation 50 ist vorteilhaft für jede Testzellenaufnahme 51 eine Batterietestvorrichtung 56 vorgesehen. In Figur 1 ist nur für die vordersten vier Testzellenaufnahmen 51 die Batterietestvorrichtung 56 schematisch gezeichnet. Jede Batterietestvorrichtung 56 weist einen Potentiostat/Galvanostat, eine Schaltmatrix, eine digitale Steuerungsvorrichtung, insbesondere einen Mikrocontroller oder Mikroprozessor, und/oder einen Datenspeicher auf. Jede Batterietestvorrichtung 56 kann auf einer separaten Platine (Kanalplatine, channel board) angeordnet sein. Alternativ ist auch eine Einplatinenlösung für sämtliche, hier sechzehn, Batterietestvorrichtungen 56 denkbar, entweder in Form einer separaten Platine oder integriert in die Platine 26. Die Batterietestvorrichtungen 56 können über einen internen Datenbus miteinander verbunden sein.

Die Batterietestvorrichtungen 56 dienen des Weiteren zum Aufzeichnen der Messdaten. Hierzu werden die Ströme und Spannungen an den Zellen 10 gemessen und die Ergebnisse beispielsweise per USB- oder LAN-Verbindung über eine interne Schnittstellenvorrichtung 60 an einen externen Datenbank-Server 58 geleitet, wo sie gespeichert und/oder visualisiert werden können. Die Schnittstellenvorrichtung 60 kann beispielsweise als Ein-Platinen-Computer EPC ausgeführt sein.

Zur Durchführung von Batterietestungen sind die elektrochemischen Zellen 10 auf einer vordefinierten Messtemperatur zu halten. Um eine gewünschte Temperatur in der Temperaturkammer 20 einstellen und halten zu können, ist ein Kühl-/Heizelement 27 vorgesehen, das eine Kühlfläche 28 aufweist, die zur Abgabe von Kälte oder Wärme in den Innenraum der Temperaturkammer 20 angeordnet und eingerichtet ist. Das Kühl-/Heizelement 27 ist vorzugsweise ein thermoelektrischer Wandler, insbesondere ein Peltierelement, das vorteilhaft in einer thermisch isolierten Wand 21 der Temperaturkammer 20 angeordnet ist, so dass eine Seite 28 des Peltierelements 27 in thermischer Verbindung mit dem Innenraum der Temperaturkammer 20 und die entgegengesetzte Seite 29 in thermischer Verbindung mit dem Außenraum 30 der Temperaturkammer 20 steht.

Das Netzteil ist zur Strom- bzw. Spannungsversorgung des Peltierelements 27 und der Elektronik in der Testzellenstation 50 eingerichtet. Je nach Polung wird die der Temperaturkammer 20 zugewandte Seite 28 oder die abgewandte Seite 29 des Peltierelements 27 gekühlt, wobei die jeweils andere Seite 29 bzw. 28 durch die Abwärme des Peltierelements 27 erwärmt wird. Im Folgenden wird ohne Beschränkung angenommen, dass das Peltierelement 27 im Kühlbetrieb betrieben wird, d.h. dass die der Temperatur- bzw. Kühlkammer 20 zugewandte Seite 28 des Peltierelements 27 durch entsprechende Polung der Stromversorgung gekühlt wird. Die der Kühlkammer 20 zugewandte Seite 28 des Peltierelements 27 wird daher im Folgenden als Kühlseite bezeichnet, obgleich sie durch umgekehrte Polung auch als Heizseite betreibbar ist. Die einstellbaren Temperaturen liegen in einem Temperaturbereich, der vorzugsweise mindestens 50 °C umspannt, beispielsweise im Bereich zwischen -10 °C und +80 °C.

Um die durch das Peltierelement 27 erzeugte Kälte wirkungsvoller an die Luft in der Temperaturkammer 20 abgeben und somit die Effizienz der Kühlung steigern zu können, ist die Kühlseite 28 des Peltierelements 27 vorteilhaft mit einem sich in die Temperaturkammer 20 erstreckenden Kühlkörper 32 aus einem Material mit hoher Wärmeleitfähigkeit, beispielsweise Aluminium, wärmeleitend verbunden. Um die gekühlte Luft wirkungsvoller in der Temperaturkammer 20 verteilen und somit die Effizienz der Kühlung weiter steigern zu können, ist vorzugsweise ein elektrischer Lüfter 33 in der Temperaturkammer 20 vorgesehen, der so angeordnet ist, dass der von dem Lüfter 33 erzeugte Luftstrom einerseits zur Kälteaufnahme an dem Kühlkörper 32 und andererseits zur Kälteabgabe an den Testzellenaufnahmen 51 bzw. elektrochemischen Zellen 10 vorbeistreicht. Der elektrische Lüfter 33 kann beispielsweise an dem Kühlkörper 32 befestigt sein. Zum Zweck einer verbesserten Kühlluftverteilung können vorteilhaft auch Luftleitwände 34 in der Temperaturkammer 20 vorgesehen sein.

Um die durch das Peltierelement 27 erzeugte Abwärme wirkungsvoller an die Umgebung abgeben zu können, ist die Warmseite 29 des Peltierelements 27 vorteilhaft mit einem sich außerhalb der Temperaturkammer 20 erstreckenden Kühlkörper 35 aus einem Material mit hoher Wärmeleitfähigkeit, beispielsweise Aluminium, wärmeleitend verbunden, beispielsweise über Wärmerohre 36 (sog. Heatpipes). Um Abwärme wirkungsvoller ableiten zu können, ist vorzugsweise ein elektrischer Lüfter 37 in dem Außenraum 30 vorgesehen, der so angeordnet ist, dass der von dem Lüfter 37 erzeugte Luftstrom zur Wärmeaufnahme an dem Kühlkörper 35 vorbeistreicht. Der elektrische Lüfter 37 kann insbesondere an dem Kühlkörper 35 befestigt sein. In dem Gehäuse 57 ist vorteilhaft eine Zuluftöffnung 38, beispielsweise in der Rückwand, zum Zuführen von kühlerer Luft aus der Umgebung, und eine Abluftöffnung 39 beispielsweise an der Vorderseite zum Abführen der warmen Luftströmung aus dem Gehäuse 57 vorgesehen. Die kühlere Zuluft streicht vorteilhaft über die elektronischen Komponenten 13, 26, 56 in dem Außenraum 30, um diese zu kühlen bzw. deren Abwärme ebenfalls abzuführen.

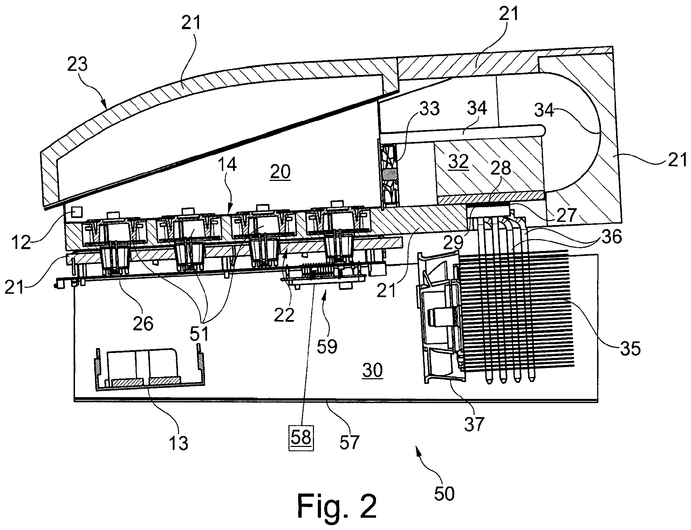

Um die Temperatur in der Temperaturkammer 20 auf einen gewünschten Wert regeln zu können, ist vorzugsweise ein in Figur 2 nur schematisch gezeigter Temperaturregler 13 vorgesehen, der die Stromversorgung des Peltierelements 27 in Abhängigkeit einer mithilfe mindestens eines in der Temperaturkammer 20 angeordneten Temperatursensors 12 gemessenen Temperatur regelt. Der Temperaturregler 13 kann beispielsweise von der Steuerungsvorrichtung 56 gesteuert werden.

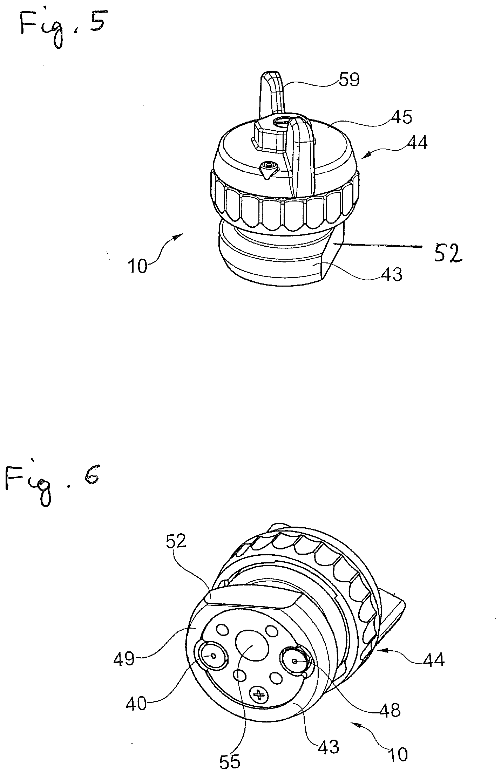

Eine als PAT-Cell bezeichnete elektrochemische Testzelle 10 gemäß den Figuren 5 und 6 umfasst eine hermetisch nach außen abgedichtete und mit einer definierten Kraft von einigen Newton beaufschlagte Innenzelle 11, die eine mit einem Referenzmaterial, beispielsweise metallischem Lithium, in Kontakt stehende Referenzelektrode, eine Arbeitselektrode und eine Gegenelektrode umfasst, wobei sämtliche Elektroden miteinander in Elektrolytkontakt stehen. Die Testzelle 10 umfasst in dieser Ausführungsform weiterhin einen vorzugsweise metallischen Sockel 43 und eine Deckelanordnung 44. In dem Sockel 43 der Testzelle 10 sind externe elektrische Anschlüsse, nämlich ein mit der Referenzelektrode verbundener Referenzanschluss 40, ein mit der Arbeitselektrode verbundener Kontaktanschluss 48 und ein mit der Gegenelektrode verbundener, hier durch den Sockel 43 gebildeter Kontaktanschluss 49 vorgesehen.

Vorzugsweise ist an der Unterseite der Testzelle 10 ein metallisches Kontaktelement 55, beispielsweise ein Kontaktknopf aus Edelstahl, vorgesehen, das bei in die Aufnahme 51 eingesetzter Zelle 10 zwei doppeltwirkende Federkontaktstifte 54 kurzschließt. Auf diese Weise ist die Anwesenheit einer Testzelle 10 in einer Aufnahme 51 einfach detektierbar.

In einer bevorzugten, PAT-Cycler genannten Ausführungsform sind die Batterietestvorrichtungen 56 mit Potentiostat und/ oder Galvanostat in die Testzellenstation 50 integriert. Beispielsweise ist unter jeder Aufnahme 51 für eine Testzelle 10 die Elektronik 56 eines Batterietester-Kanals mit Potentiostat und/oder Galvanostat angeordnet, siehe Figur 1. Die von der Batterietestvorrichtung erzeugten Spannungen bzw. Ströme werden über die Verbindungsmittel 54 und die externen Anschlüsse 40, 48, 49 an die Elektroden der Testzellen 10 angelegt, um Lade- bzw. Entladekurven der elektrochemischen Zelle 10 aufzunehmen und Impedanzmessungen durchzuführen. Die Platine 26 dient insbesondere zur Übermittlung der Spannungen bzw. Ströme von den Batterietestvorrichtungen 56 zu den Testzellen 10. Eine Schnittstellenvorrichtung 60, beispielsweise ein interner Dateiserver, dient zur Übermittlung der Daten von den Batterietestvorrichtungen 56 zu einem externen Datenbank-Server 58.

Vorzugsweise sind die Batterietestvorrichtungen 56 in dem Gehäuse 57 in dem Außenraum 30 angeordnet. Aufgrund der Anordnung im Gehäuse 57 entfällt die aufwändige und fehleranfällige individuelle Verkabelung zwischen der Dockingstation 14 und einem externen Batterietester durch den Bediener und damit auch die durch die Verkabelung entstehenden Messartefakte.

In einer anderen, PAT-Chamber genannten Ausführungsform ist die Batterietestvorrichtung nicht in die Testzellenstation 50 integriert, sondern ist eine externe Einheit, die mit der Testzellenstation 50 über eine Kabelverbindung verbindbar ist. In dieser Ausführungsform ist in dem Gehäuse der Testzellenstation 50 vorzugsweise ein Datenlogger 59 zum Aufzeichnen von Ladekennlinien und Sensorsignalen integriert, der vorteilhaft mit einem externen Datenbank-Server 58 verbindbar ist. Ein aus dem Stand der Technik bekannter externer Datenlogger und die entsprechenden Verbindungskabel von dem externen Datenlogger zu der Testzellenstation 50 sind dann entbehrlich.

Vorteilhaft weist jede Batterietestvorrichtung 56 eine steuerbare elektronische Schaltmatrix auf, insbesondere in Form einer Mehrzahl von Schaltern, beispielsweise Halbleiterschaltern oder Relais, mit der die Anschlüsse des jeweiligen Potentio-/Galvanostaten (Arbeits-, Gegen-, Referenzelektrode) beliebig mit den Anschlüssen 40, 48, 49 der entsprechenden Testzelle (Anode, Kathode, Referenzelektrode) verbunden werden können. Beispiele für unterschiedliche Testzellenbeschaltungen, die mittels der Schaltmatrix einstellbar sind, sind im potentiostatischen (cv) Betrieb: konstante Zellenspannung; konstantes Kathodenpotential; konstantes Anodenpotential; Ladung der Referenzelektrode gegen die Kathode; Ladung der Referenzelektrode gegen die Anode. Im galvanostatischen (cc) Betrieb: konstanter Zellenstrom; Ladung der Referenzelektrode gegen die Kathode galvanostatisch; Ladung der Referenzelektrode gegen die Anode galvanostatisch. Des Weiteren Messung der Ruhespannungen im stromlosen Zustand (open circuits). Durch das elektronisch gesteuerte Umschalten mittels der Schaltmatrix können fehleranfällige und zeitaufwändige manuelle Änderungen der Testzellenbeschaltung durch Umstecken von elektrischen Kabeln entfallen. Auch eine Dokumentation der Testzellenbeschaltung ist rechnergesteuert einfach möglich.

Nach dem zuvor Gesagten sind die Aufnahmen 51 bzw. die Docking-Station 14 fest in der Temperaturkammer 20 montiert. Mit anderen Worten sind die Docking-Station 14 und die Temperaturkammer 20 in ein einheitliches Gerät, nämlich in die Testzellenstation 50, integriert.

In der Ausführungsform gemäß den Figuren 1, 2 und 4 umschließt das Gehäuse 57 vorteilhaft im Wesentlichen zwei Unterbereiche, nämlich einerseits die wärmeisolierte Temperaturkammer 20 für die Testzellen 10 und andererseits den Außenraum 30 für elektronische Komponenten wie Netzteil, Temperaturregler 13, Platine 26 und/oder Steuerungsvorrichtung 56. Es ist denkbar, einzelne oder sämtliche dieser elektronischen Komponenten alternativ in der Temperaturkammer 20 anzuordnen. Es ist auch denkbar, dass die Zwischenwand 22 thermisch nicht isoliert und stattdessen der Boden des Gehäuses 57 thermisch isoliert ist. Mindestens die Warmseite 29 des Peltierelements und der Kühlkörper 35 sind jedoch vorteilhaft in thermischer Verbindung mit dem Außenraum 30 der Temperaturkammer 20, und nicht deren Innenraum, angeordnet.

## Patentansprüche

1. Testzellenstation (50) für mindestens eine elektrochemische Testzelle (10), umfassend ein Gehäuse (57), mindestens eine Aufnahme (51) zum kontaktierenden Einsetzen mindestens einer elektrochemischen Testzelle (10) und elektrische Verbindungsmittel (54) zur elektrischen Verbindung einer in die Aufnahme (51) eingesetzten Testzelle (10), wobei in die Testzellenstation (50) eine wärmeisolierte Temperaturkammer (20) mit einer steuerbaren Kühl-/Heizeinrichtung (27) zum Einstellen einer Temperatur in der Temperaturkammer (20) integriert ist, wobei die Aufnahme (51) so in der Testzellenstation (50) angeordnet ist, dass der entsprechende Aufnahmeraum für die elektrochemische Testzelle (10) innerhalb der Temperaturkammer (20) angeordnet ist, **dadurch gekennzeichnet, dass** für jede Aufnahme (51) eine Batterietestvorrichtung (56) mit einem steuerbaren Potentiostat und/oder Galvanostat in die Testzellenstation (50) integriert ist und die Batterietestvorrichtung (56) in dem Gehäuse (57) außerhalb der Temperaturkammer (20) angeordnet ist, und die elektrischen Verbindungsmittel (54) durch eine Zwischenwand (22) in dem Gehäuse (57) geführt sind.

2. Testzellenstation nach Anspruch 1, **dadurch gekennzeichnet, dass** jede Batterietestvorrichtung (56) eine steuerbare elektronische Schaltmatrix aufweist, mit der die Anschlüsse des Potentio-/Galvanostaten beliebig mit den Anschlüssen der entsprechenden Testzellenaufnahme (51) verbunden werden können.

3. Testzellenstation nach einem der Ansprüche 1 oder 2, **dadurch gekennzeichnet, dass** jede Batterietestvorrichtung (56) eine digitale Steuerungseinrichtung zum Steuern des Potentio-/Galvanostaten und/oder der Schaltmatrix umfasst.

4. Testzellenstation nach einem der vorangehenden Ansprüche, **dadurch gekennzeichnet, dass** die Kühl-/Heizeinrichtung (27) ein Peltierelement ist, wobei die eine thermische Seite (28) mit dem Innenraum und die andere thermische Seite (29) mit dem Außenraum der Temperaturkammer (20) in thermischer Verbindung steht.

5. Testzellenstation nach Anspruch 4, **dadurch gekennzeichnet, dass** im Innenraum und/oder im Außenraum der Temperaturkammer (20) ein mit der jeweiligen thermischen Seite (28, 29) des Peltierelements wärmeleitend verbundener Kühlkörper (32, 35) vorgesehen ist.

6. Testzellenstation nach Anspruch 5, **dadurch gekennzeichnet, dass** im Innenraum und/oder im Außenraum der Temperaturkammer (20) ein dem jeweiligen Kühlkörper zugeordneter Lüfter (33, 37) vorgesehen ist.

7. Testzellenstation nach einem der vorangehenden Ansprüche, **dadurch gekennzeichnet, dass** mindestens ein Temperatursensor (12) und ein Temperaturregler (13) zum Regeln der Kühl-/Heizeinrichtung (27) vorgesehen ist.

8. Testzellenstation nach einem der vorangehenden Ansprüche, **dadurch gekennzeichnet, dass** an dem Gehäuse (57) eine thermisch isolierte, verstellbare Klappe (23) zum Öffnen bzw. Verschließen einer Gehäuseöffnung in der Temperaturkammer (20) angebracht ist.

9. Testzellenstation nach einem der vorangehenden Ansprüche, **dadurch gekennzeichnet, dass** die mindestens eine Aufnahme (51) in einem aus dem Gehäuse herausziehbaren und wieder einschiebbaren Schubelement angeordnet ist, das eine thermisch isolierte Frontwand aufweist.

10. Testzellenstation nach einem der vorangehenden Ansprüche, **dadurch gekennzeichnet, dass** in dem Gehäuse (57) eine mit den Verbindungsmitteln (54) verbundene Platine (26) vorgesehen ist.

11. Testzellenstation nach einem der vorangehenden Ansprüche, **dadurch gekennzeichnet, dass** die elektrischen Verbindungsmittel (54) Federkontaktstifte sind.

## Claims

1. Test cell station (50) for at least one electrochemical test cell (10), comprising a housing (57), at least one receptacle (51) for contacting insertion of at least one electrochemical test cell (10) and electrical connection means (54) for electrical connection of a test cell (10) inserted into the receptacle (51), wherein a thermally insulated temperature chamber (20) with a controllable cooling/heating device (27) for setting a temperature in the temperature chamber (20) is integrated into the test cell station (50), wherein the receptacle (51) is arranged in the test cell station (50) in such a way that the corresponding receiving space for the electrochemical test cell (10) is arranged within the temperature chamber (20), **characterized in that** a battery test device (56) with a controllable potentiostat and/or galvanostat is integrated into the test cell station (50) for each receptacle (51) and the battery test device (56) is arranged in the housing (57) outside the temperature chamber (20), and the electrical connection means (54) are guided through an intermediate wall (22) in the housing (57).

2. Test cell station according to claim 1, **characterized in that** each battery test device (56) comprises a controllable electronic switching matrix with which the terminals of the potentiostat/galvanostat can be connected as desired to the terminals of the corresponding test cell receptacle (51).

3. Test cell station according to any one of claims 1 or 2, **characterized in that** each battery test device (56) comprises a digital control device for controlling the potentio/galvanostat and/or the switching matrix.

4. Test cell station according to any one of the preceding claims, **characterized in that** the cooling/heating device (27) is a Peltier element, wherein one thermal side (28) is in thermal communication with the interior and the other thermal side (29) is in thermal communication with the exterior of the temperature chamber (20).

5. Test cell station according to claim 4, **characterized in that** a heatsink (32, 35) connected in a thermally conductive manner to the respective thermal side (28, 29) of the Peltier element is provided in the interior and/or in the exterior of the temperature chamber (20).

6. Test cell station according to claim 5, **characterized in that** a fan (33, 37) associated with the respective heatsink is provided in the interior and/or in the exterior of the temperature chamber (20).

7. Test cell station according to any one of the preceding claims, **characterized in that** at least one temperature sensor (12) and one temperature controller (13) are provided for controlling the cooling/heating device (27).

8. Test cell station according to any one of the preceding claims, **characterized in that** a thermally insulated, adjustable flap (23) for opening or closing a housing opening in the temperature chamber (20) is attached to the housing (57).

9. Test cell station according to any one of the preceding claims, **characterized in that** the at least one receptacle (51) is arranged in a sliding element which can be pulled out of the housing and pushed back in again and comprises a thermally insulated front wall.

10. Test cell station according to any one of the preceding claims, **characterized in that** a circuit board (26) connected to the connecting means (54) is provided in the housing (57).

11. Test cell station according to any one of the preceding claims, **characterized in that** the electrical connecting means (54) are spring contact pins.

## Revendications

1. Station de cellules de test (50) pour au moins une cellule de test électrochimique (10), comprenant un boîtier (57), au moins un logement (51) pour l'insertion avec contact d'au moins une cellule de test électrochimique (10) et des moyens de liaison électrique (54) pour la liaison électrique d'une cellule de test (10) insérée dans le logement (51), une chambre de température (20) isolée thermiquement, dotée d'un système de refroidissement/chauffage (27) commandable pour régler une température dans la chambre de température (20), étant intégrée dans la station de cellules de test (50), le logement (51) étant disposé dans la station de cellules de test (50) de telle sorte que l'espace de logement correspondant pour la cellule de test électrochimique (10) soit disposé à l'intérieur de la chambre de température (20), **caractérisée en ce que**, pour chaque logement (51), un dispositif de test de batterie (56) avec un potentiostat et/ou un galvanostat commandable est intégré dans la station de cellules de test (50) et le dispositif de test de batterie (56) est disposé dans le boîtier (57) à l'extérieur de la chambre de température (20), et les moyens de liaison électrique (54) sont passés à travers une paroi intermédiaire (22) du boîtier (57).

2. Station de cellules de test selon la revendication 1, **caractérisée en ce que** chaque dispositif de test de batterie (56) présente une matrice de commutation électronique commandable qui permet de relier au choix les bornes du potentio-/galvanostat aux bornes du logement de cellule de test (51) correspondant.

3. Station de cellules de test selon l'une des revendications 1 ou 2, **caractérisée en ce que** chaque dispositif de test de batterie (56) comprend un système de commande numérique pour commander le potentio-/galvanostat et/ou la matrice de commutation.

4. Station de cellules de test selon l'une des revendications précédentes, **caractérisée en ce que** le système de refroidissement/chauffage (27) est un élément Peltier, un côté thermique (28) étant en communication thermique avec l'espace intérieur et l'autre côté thermique (29) avec l'espace extérieur de la chambre de température (20).

5. Station de cellules de test selon la revendication 4, **caractérisée en ce qu'**il est prévu dans l'espace intérieur et/ou dans l'espace extérieur de la chambre de température (20) un corps de refroidissement (32, 35) relié de manière thermoconductrice au côté thermique respectif (28, 29) de l'élément Peltier.

6. Station de cellules de test selon la revendication 5, **caractérisée en ce qu'**un ventilateur (33, 37) associé au corps de refroidissement respectif est prévu dans l'espace intérieur et/ou dans l'espace extérieur de la chambre de température (20).

7. Station de cellules de test selon l'une des revendications précédentes, **caractérisée en ce qu'**il est prévu au moins un capteur de température (12) et un régulateur de température (13) pour réguler le système de refroidissement/chauffage (27).

8. Station de cellules de test selon l'une des revendications précédentes, **caractérisée en ce qu'**un volet réglable (23), isolé thermiquement, est monté sur le boîtier (57) pour ouvrir ou fermer une ouverture de boîtier dans la chambre de température (20).

9. Station de cellules de test selon l'une des revendications précédentes, **caractérisée en ce que** ledit au moins un logement (51) est disposé dans un élément de poussée pouvant être extrait du boîtier et y être réinséré, qui présente une paroi frontale isolée thermiquement.

10. Station de cellules de test selon l'une des revendications précédentes, **caractérisée en ce qu'**une carte de circuit imprimé (26) reliée aux moyens de liaison (54) est prévue dans le boîtier (57).

11. Station de cellules de test selon l'une des revendications précédentes, **caractérisée en ce que** les moyens de liaison électrique (54) sont des broches de contact à ressort.
